# EUROPEAN PATENT SPECIFICATION

(11) **EP 3 712 909 B1**
(45) Date of publication and mention of the grant of the patent: **25.06.2025**
(21) Application number: 18910523.2
(22) Date of filing: 20.12.2018
(51) Int. Cl.: H01C 13/00, G01R 15/00, H01C 3/00, H01C 17/28, H01C 1/14, H01C 7/06, H01C 17/065

(54) **SHUNT RESISTOR AND METHOD FOR MANUFACTURING SAME**
SHUNT-WIDERSTAND UND VERFAHREN ZUR HERSTELLUNG DAVON
RÉSISTANCE DE DÉRIVATION ET SON PROCÉDÉ DE FABRICATION

(30) Priority: 19.03.2018 JP 2018050715
(43) Date of publication of application: 23.09.2020
(73) Proprietor: Suncall Corporation, Kyoto-shi, Kyoto 615-8555 (JP)
(72) Inventor: MURAKAMI, Kenji, Kyoto-shi, Kyoto 615-8555 (JP)
(74) Representative: Hoffmann Eitle
(86) International application number: PCT/JP2018/046915
(87) International publication number: WO 2019/181117

(56) References cited:
- WO-A1-2006/067300
- DE-T5- 112016 002 705
- JP-A- 2016 152 365
- JP-A- 2016 152 365
- US-A1- 2016 139 211
- US-A1- 2017 307 658

## Description

### Technical Field

The present invention relates to shunt resistors and, in particular, to a shunt resistor used to measure the current value on a current path through which a large current flows from a battery for high-voltage applications to a motor circuit that are used in, for example, electric vehicles (EVs), hybrid vehicles (HVs), and plug-in hybrid vehicles (PHVs), and to a method for manufacturing such a shunt resistor.

Shunt resistors have conventionally been known such as that described in JP 2009 244 065 A. As shown in FIG. 4, the shunt resistor 100 includes two plate-shaped base materials joined by welding 101a with a resistance element 101 with the resistance element 101 therebetween and a measurement terminal portion 103 joined to each of the base materials 102 by welding 103a. It is noted that the reference sign 102a designates a circular bolt hole for a shaft part of an insulated bolt not shown to pass therethrough.

A shunt resistor and method for manufacturing same is also known from US 2017/307658 A1, DE 11 2016 002705 T5, and JP 2016 152365 A.

### Summary of the Invention

### Technical Problem

Incidentally, when a current flows through the above-described shunt resistor 100, the resistance element 101 generates heat and thereby undergoes a change in the resistance value depending on the heat generation temperature. To address this, the resistance element 101 is required to have a lower resistance value in order not to result in an increase in the heat generation temperature. It is said, for example, that if a large current of 400 A flows through the shunt resistor 100, the resistance element 101 preferably has a resistance value of about 100 µΩ, and if a large current of 1000 A flows through the shunt resistor 100, the resistance element 101 preferably has a resistance value of about 30 µΩ to 50 µΩ.

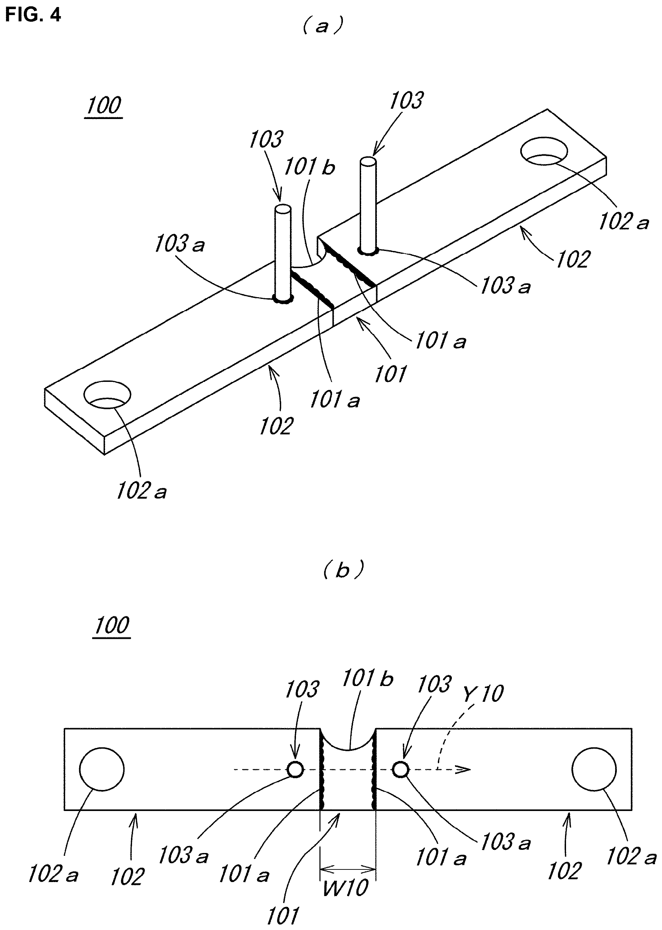

Here, since it is known that the resistance value of the resistance element 101 varies depending on the size of the resistance element 101 itself, a method for adjusting the resistance value of the resistance element 101 has commonly been known in which a recess-shaped notched portion 101b is provided in the resistance element 101 to reduce the size of the resistance element 101 itself, as shown in FIG. 4.

In such a method, however, when a current flows from the base material 102 shown on the left side to the base material 102 shown on the right side as shown in FIG. 4 (b) (see the direction indicated by the arrow Y10), since the current does not flow in the notched portion 101b provided in the resistance element 101, there has been a problem such that the current value may not be measured accurately.

Hence, it is considered to reduce the width W10 (see FIG. 4 (b)) of the resistance element 101 in order to lower the resistance value of the resistance element 101. For example, it is required that the resistance element 101 has a width W10 (see FIG. 4 (b)) of about 8 mm so as to have a resistance value of 100 µΩ, while the resistance element 101 has a width W10 (see FIG. 4 (b)) of about 3 mm so as to have a resistance value of 30 µΩ to 50 µΩ.

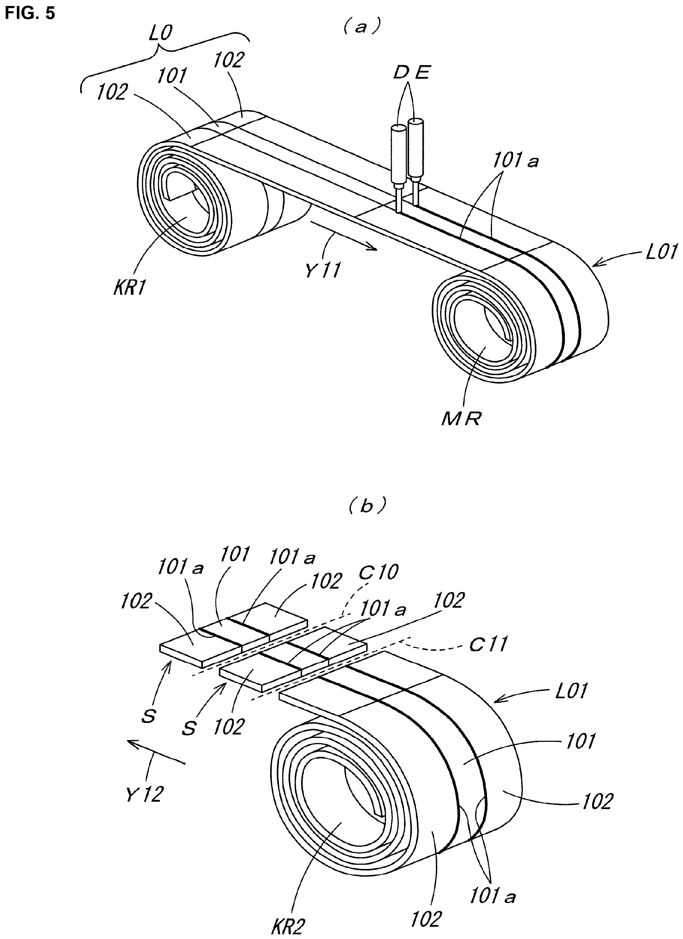

However, thus reducing the width W10 (see FIG. 4 (b)) of the resistance element 101 suffers from a problem, for example, that it is very difficult to join the resistance element 101 and the two base materials 102 by welding 101a of the resistance element 101, with the resistance element being sandwiched between the two base materials 102. In particular, manufacturing of conventional shunt resistors 100, in which a continuous welding method is employed, significantly suffers from this problem. That is, in the continuous welding method, as shown in FIG. 5 (a), a long object LO with a resistance element 101 between two base materials 102 wound around a feed roll KR1 is fed from the feed roll KR1 in the direction indicated by the arrow Y11, and within the fed long object LO, portions in which the resistance element 101 is in close proximity to the two respective base materials 102 undergo welding 101a using an electron beam DE. As a result, this causes the two base materials 102 with the resistance element 101 therebetween to be joined by welding 101a to the resistance element 101. It is noted that the long object LO1 after welding using an electron beam DE is to be wound around a take-up roll MR, as shown in FIG. 5 (a). Then, the long object LO1 wound around the take-up roll MR is to be wound around a feed roll KR2, as shown in FIG. 5 (b), and then fed from the feed roll KR2 in the direction indicated by the arrow Y12. The long object LO1 thus fed from the feed roll KR2 is to be cut by a cutting blade not shown at predetermined intervals in the direction perpendicular to the feed direction (indicated by the arrow Y12 in FIG. 5 (b)) (see C10, C11 shown in FIG. 5 (b)). After thus cutting the long object LO1 at predetermined intervals, a bolt hole 102a (see FIG. 4) is to be provided in a vertically penetrating manner in each of the base materials 102 of each cut piece S, and further a measurement terminal portion 103 is to be joined by welding 103a (see FIG. 4) to each of the base materials 102, whereby such a shunt resistor 100 as shown in FIG. 4 is manufactured.

However, in such a continuous welding method as above, since the long object LO with the resistance element 101 between the two base materials 102 is fed continuously from the feed roll KR1, sufficient allowances for welding are required to join the resistance element 101 and the two base materials 102 reliably by welding 101a. For this reason, reducing the width W10 (see FIG. 4 (b)) of the resistance element 101 suffers from a problem, for example, that sufficient allowances for welding are not provided and poor joints may occur, whereby the current value may not be measured accurately.

The present invention has hence been made in consideration of the above-described problem, and an object thereof is to provide a shunt resistor capable of measuring a current value accurately even when a large current flows therethrough, and a method for manufacturing such a shunt resistor.

### Solution to the Problem

The foregoing object of the present invention is achieved by the following means. It is noted that reference signs in the embodiments to be described hereinafter are added in parentheses, but the present invention is not intended to be limited thereto.

The invention of claim 1 is characterized by including:
a resistance element (10); and
two base materials (11) joined by welding (10e) to the resistance element (10) with the resistance element (10) therebetween, in which
the resistance element (10) is provided with a protruding portion (first protruding portion 10a) that protrudes from at least one (11a) of longitudinal side surfaces (one side surface 11a, the other side surface 11b) of the two base materials (11) characterized in that the protruding portion is formed so as to have a height (H1, H2) of 2 to 5 mm.

In accordance with the invention of claim 2, the shunt resistor (1) according to claim 1 is also characterized in that
the resistance element (10) is provided with protruding portions (first protruding portion 10a, second protruding portion 10b) that protrude from the longitudinal side surfaces (one side surface 11a, the other side surface 11b) of the two base materials (11).

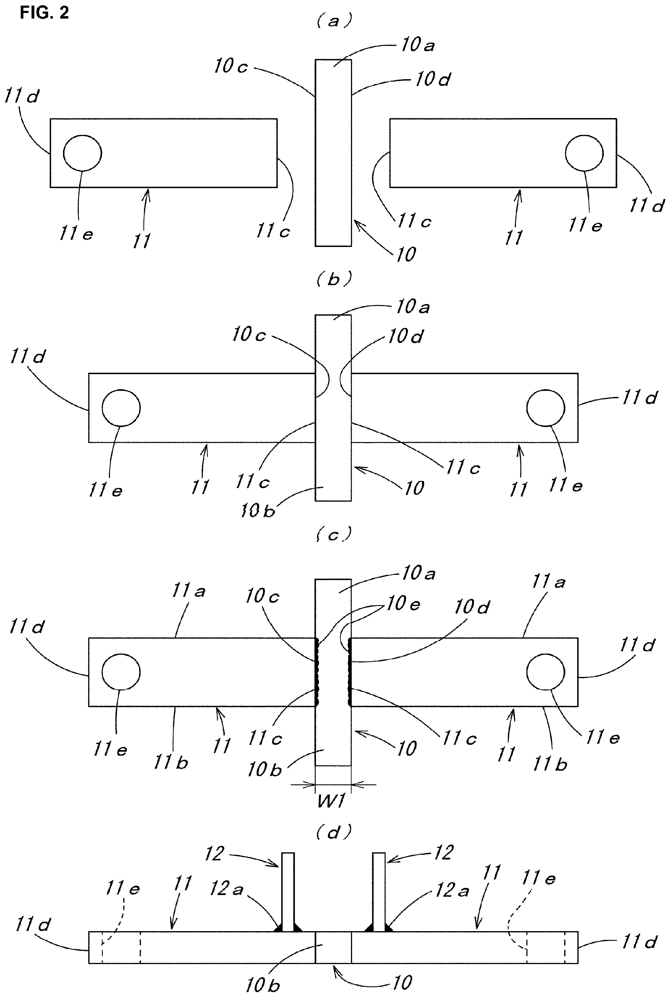

On the other hand, the invention of claim 3 is a method for manufacturing a shunt resistor according to claim 1 and is characterized by including:
forming a resistance element (10) so as to be provided with a protruding portion (first protruding portion 10a) that protrudes from at least one (11a) of the longitudinal side surfaces (one side surface 11a, the other side surface 11b) of two base materials (11) when the resistance element (10) is sandwiched between the two base materials (11) (see FIG. 2 (a)); and
clamping and joining by welding (10e) the protruding portion (first protruding portion 10a) of the resistance element (10) and the two base materials (11) when joining by welding (10e) the two base materials (11) to the resistance element (10) with the resistance element (10) therebetween (see FIGS. 2 (b) and 2 (c)).

### Advantageous Effects of the Invention

Next will be described advantageous effects of the present invention based on designation by the reference signs in the drawings. It is noted that reference signs in the embodiments to be described hereinafter are added in parentheses, but the present invention is not intended to be limited thereto.

In accordance with the invention of claim 1, since the resistance element (10) is provided with the protruding portion (first protruding portion 10a) that protrudes from at least one (11a) of the longitudinal side surfaces (one side surface 11a, the other side surface 11b) of the two base materials (11), the two base materials (11) and the protruding portion (first protruding portion 10a) of the resistance element (10) can be clamped by a well-known clamping mechanism not shown. This allows to join the two base materials (11) and the resistance element (10) therebetween by welding (10e) while ensuring a sufficient welding bead width, whereby this makes it possible to realize welding of high quality in which poor joints are less likely to occur.

The present invention can thus achieve an accurate current value measurement even when a large current flows.

Also, in accordance with the invention of claim 2, since the resistance element (10) is provided with the protruding portions (first protruding portion 10a, second protruding portion 10b) that protrude from the longitudinal side surfaces (one side surface 11a, the other side surface 11b) of the two base materials (11), the resistance element (10) can be clamped stably by a well-known clamping mechanism not shown.

On the other hand, in accordance with the invention of claim 3, the resistance element (10) is formed to be provided with the protruding portion (first protruding portion 10a) that protrudes from at least one (11a) of the longitudinal side surfaces (one side surface 11a, the other side surface 11b) of the two base materials (11) when the resistance element (10) is sandwiched between the two base materials (11) (see FIG. 2 (a)), and the protruding portion (first protruding portion 10a) of the resistance element (10) and the two base materials (11) are clamped and joined by welding (10e) when joining by welding (10e) the two base materials (11) to the resistance element (10) with the resistance element (10) therebetween (see FIGS. 2 (b) and 2 (c)), which allows to join the two base materials (11) and the resistance element (10) therebetween by welding (10e) while ensuring a sufficient welding bead width, whereby makes it possible to realize welding of high quality in which poor joints are less likely to occur.

The present invention can thus achieve an accurate current value measurement even when a large current flows.

### Brief Description of the Drawings

FIG. 1 (a) is a perspective view of a shunt resistor according to an embodiment of the present invention and FIG. 1 (b) is a plan view of the shunt resistor according to the embodiment.
FIG. 2 shows a process of manufacturing the shunt resistor according to the embodiment, where FIG. 2 (a) is a plan view showing a state where two base materials and a resistance element according to the embodiment are prepared separately, FIG. 2 (b) is a plan view showing a state where the resistance element prepared as shown in FIG. 2 (a) is sandwiched between the two base materials, FIG. 2 (c) is a plan view showing a state where the two base materials and the resistance element are joined by welding after the state shown in FIG. 2 (b), and FIG. 2 (d) is a front view showing a state where measurement terminals are joined by welding to the two respective base materials after the state shown in FIG. 2 (c).
FIG. 3 is a perspective view of a shunt resistor according to another embodiment.
FIG. 4 (a) is a perspective view of a conventional shunt resistor and FIG. 4 (b) is a plan view of the conventional shunt resistor.
FIG. 5 (a) is an illustrative view illustrating a state of continuous welding with a conventional resistance element being sandwiched between two conventional base materials and FIG. 5 (b) is an illustrative view illustrating a state where the object after continuous welding as shown in FIG. 5 (a) is being cut at predetermined intervals.

### Description of the Embodiments

An embodiment of a shunt resistor according to the present invention will hereinafter be described specifically with reference to the accompanying drawings. It is noted that in the following description, reference to vertical and horizontal directions will denote the vertical and horizontal directions in a front view of the drawings.

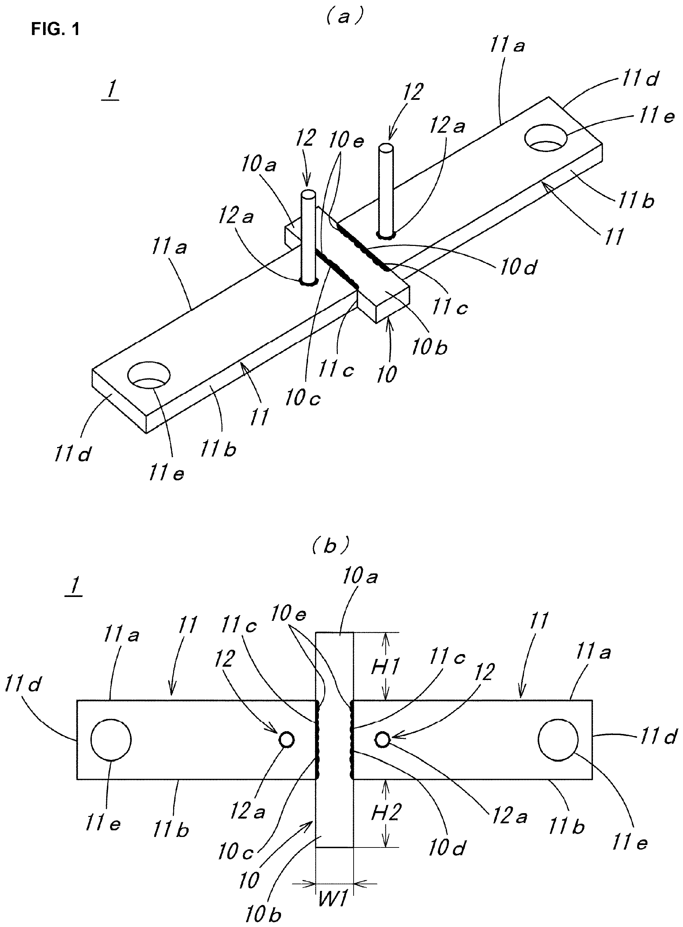

The shunt resistor according to this embodiment is particularly used to measure the current value on a current path through which a large current flows from a battery for high-voltage applications to a motor circuit that are used in, for example, electric vehicles (EVs), hybrid vehicles (HVs), and plug-in hybrid vehicles (PHVs), the shunt resistor 1 including a resistance element 10, two base materials 11 formed integrally by welding 10e with the resistance element 10 therebetween, and a measurement terminal 12 fixed by welding 12a in a standing manner on each of the two base materials 11, as shown in FIG. 1.

The resistance element 10 can withstand a large current of even 1000 A, and formed in, for example, a thickened and shortened rectangular shape with a thickness of about 3 mm to 5 mm as shown in FIG. 1 (a), while having a reduced width W1 of about 3 mm as shown in FIG. 1 (b). Further, the resistance element 10 is preferably formed of, for example, Cu-Mn alloy, Cu-Ni alloy, or Ni-Cr alloy, having a resistance value of about 30 µΩ to 50 µΩ so as to withstand a large current of even 1000 A.

As shown in FIG. 1 (b), on the upper side of the thus formed resistance element 10 is provided a first protruding portion 10a that protrudes outward from one longitudinal side surface 11a (upper surface in the drawing) of the two base materials 11 when the resistance element 10 is sandwiched between lateral side surfaces 11c of the two respective base materials 11 (the right side surface of the base material 11 on the left side and the left side surface of the base material 11 on the right side in the drawing). As shown in FIG. 1 (b), on the lower side of the resistance element 10 is further provided a second protruding portion 10b that protrudes outward from the other longitudinal side surface 11b (lower surface in the drawing) of the two base materials 11 when the resistance element 10 is sandwiched between lateral side surfaces 11c of the two respective base materials 11 (the right side surface of the base material 11 on the left side and the left side surface of the base material 11 on the right side in the drawing).

Incidentally, in the thus arranged resistance element 10, the first protruding portion 10a is provided so as to have a height (length) H1 (see FIG. 1 (b)) of 2 to 5 mm, and the second protruding portion 10b is also provided so as to have a height (length) H2 (see FIG. 1 (b)) of 2 to 5 mm. It is noted that the height (length) H1 (see FIG. 1 (b)) of the first protruding portion 10a and the height (length) H2 (see FIG. 1 (b)) of the second protruding portion 10b may be set to have the same value or set to have respective different values.

On the other hand, as shown in FIGS. 1 (a) and 1 (b), the resistance element 10 has left and right side surfaces 10c, 10d that contact with the lateral side surfaces 11c of the two respective base materials 11 (the right side surface of the base material 11 on the left side and the left side surface of the base material 11 on the right side in the drawing) when the resistance element 10 is sandwiched between the side surfaces 11c of the two base materials 11, in which the base material 11 on the left side in the drawing is joined by welding 10e to the left side surface 10c of the resistance element 10, while the base material 11 on the right side in the drawing is joined by welding 10e to the right side surface 10c of the resistance element 10. This causes the resistance element 10 and the two base materials 11 to be formed integrally by welding 10e.

The base materials 11 are so-called bus bars, made of metal such as copper, and formed in, for example, a thickened and lengthened rectangular shape with a thickness of about 3 mm to 5 mm, as shown in FIG. 1 (a). Closer to the other lateral side surface 11d of each of the base materials 11 (opposite to the joint with the resistance element 10) is formed in a vertically penetrating manner a circular bolt hole 11e for a shaft part of an insulated bolt not shown to pass therethrough.

The measurement terminal 12, on which a printed circuit board for current detection can be mounted, is formed by, for example, copper or tin plating and fixed by welding 12a in a standing manner on each of the two base materials 11, as shown in FIG. 1.

A process of manufacturing the thus arranged shunt resistor 1 will next be described specifically with reference to FIG. 2.

First, as shown in FIG. 2 (a), two base materials 11 are prepared each with a bolt hole 11e formed closer to the other side surface 11d in a vertically penetrating manner. Further, a resistance element 10 is then prepared with such a first protruding portion 10a and a second protruding portion 10b as described above.

Next, the thus prepared two base materials 11 and the first protruding portion 10a and the second protruding portion 10b of the resistance element 10 are clamped by a well-known clamping mechanism not shown and, in this state, the side surfaces 11c of the two base materials 11 are brought into contact with the left and right side surfaces 10c, 10d of the resistance element 10 so that the resistance element 10 is sandwiched between the two base materials 11, as shown in FIG. 2 (b).

Next, in this state, laser welding not shown is used under a non-vacuum environment to join the side surface 11c of the base material 11 on the left side in the drawing by welding 10e to the left side surface 10c of the resistance element 10, while joining the side surface 11c of the base material 11 on the right side in the drawing by welding 10e to the right side surface 10d of the resistance element 10, as shown in FIG. 2 (c). This causes the two base materials 11 and the resistance element 10 to be formed integrally by welding 10e.

Accordingly, the side surface 11c of the base material 11 on the left side in the drawing can thus be joined by welding 10e to the left side surface 10c of the resistance element 10, while the side surface 11c of the base material 11 on the right side in the drawing can be joined by welding 10e to the right side surface 10d of the resistance element 10, even when the resistance element 10 has a reduced width W1 (see FIGS. 1 (b) and 2 (c)) of about 3 mm. That is, since the welding 10e only requires a welding bead width of as small as 0.7 mm to 1 mm, and even if the welding bead width for the welding 10e may be 1 mm, the resistance element 10 having a width W1 (see FIGS. 1 (b) and 2 (c)) of about 3 mm can ensure a sufficient welding bead width. Accordingly, the side surface 11c of the base material 11 on the left side in the drawing can be joined by welding 10e to the left side surface 10c of the resistance element 10, while the side surface 11c of the base material 11 on the right side in the drawing can be joined by welding 10e to the right side surface 10d of the resistance element 10, even when the resistance element 10 has a reduced width W1 (see FIGS. 1 (b) and 2 (c)) of about 3 mm. That is, this makes it possible to provide welding of high quality. As a result, poor joints are less likely to occur.

In this embodiment, the resistance element 10 is thus provided with the first protruding portion 10a and the second protruding portion 10b so as to be clamped by a well-known clamping mechanism not shown in order to ensure a sufficient welding bead width, even when the resistance element 10 has a reduced width W1 (see FIGS. 1 (b) and 2 (c)) of about 3 mm. This allows the resistance element 10 to be clamped by a well-known clamping mechanism not shown while ensuring a sufficient welding bead width, even when the resistance element 10 has a reduced width W1 (see FIGS. 1 (b) and 2 (c)) of about 3 mm, whereby this makes it possible to realize welding of high quality and poor joints are less likely to occur.

If the resistance element 10 had such a structure as that of the resistance element 101 shown in FIG. 4 and if the resistance element 10 has a reduced width W1 (see FIGS. 1 (b) and 2 (c)) of about 3 mm, the well-known clamping mechanism used for clamping the resistance element 10 having such a structure as that of the resistance element 101 shown in FIG. 4 would become an impediment and it would be very difficult to ensure a welding bead width of about 0.7 mm to 1 mm. This makes it difficult to provide high-quality welding and poor joints are therefore likely to occur.

For this reason, in this embodiment, the resistance element 10 is provided with the first protruding portion 10a and the second protruding portion 10b for clamping by a well-known clamping mechanism not shown in order to ensure a sufficient welding bead width.

On the other hand, in the conventional continuous welding method, as shown in FIG. 5 (a), a long object LO with a resistance element 101 between two base materials 102 wound around a feed roll KR1 is fed from the feed roll KR1 in the direction indicated by the arrow Y11, and within the fed long object LO, portions in which the resistance element 101 is in close proximity to the two respective base materials 102 undergo welding 101a using an electron beam DE, which does not allow the resistance element 101 shown in FIG. 5 (a) to have such a shape as that of the resistance element 10 described in this embodiment, which is provided with the first protruding portion 10a and the second protruding portion 10b.

For this reason, in this embodiment, unlike the conventional continuous welding method, two base materials 11 are prepared each with a bolt hole 11e formed closer to the other side surface 11d in a vertically penetrating manner, and further a resistance element 10 is prepared with such a first protruding portion 10a and a second protruding portion 10b as described above as shown in FIG. 2 (a) and, in this state, the thus prepared two base materials 11 and the first protruding portion 10a and the second protruding portion 10b of the resistance element 10 are clamped by a well-known clamping mechanism not shown so that the two base materials 11 and the resistance element 10 therebetween are formed integrally by welding 10e.

Accordingly, this makes it possible to realize welding of high quality in which poor joints are less likely to occur even when the resistance element 10 has a reduced width.

After the welding as shown in FIG. 2 (c) above, a measurement terminal 12 is fixed by welding 12a in a standing manner on each of the two base materials 11, as shown in FIG. 2 (d), with which such a shunt resistor 1 as shown in FIG. 1 is manufactured.

Thus, in accordance with this embodiment having been described above, since the resistance element 10 is provided with the first protruding portion 10a that protrudes outward from the one longitudinal side surface 11a (upper surface in the drawing) of the two base materials 11 and the second protruding portion 10b that protrudes outward from the other longitudinal side surface 11b (lower surface in the drawing) of the two base materials 11, the two base materials 11 and the first protruding portion 10a and the second protruding portion 10b of the resistance element 10 can be clamped by a well-known clamping mechanism not shown. This allows to form the two base materials 11 and the resistance element 10 therebetween integrally by welding 10e while ensuring a sufficient welding bead width, whereby this makes it possible to realize welding of high quality in which poor joints are less likely to occur.

This embodiment can thus achieve an accurate current value measurement even when a large current flows.

According to the invention, the first protruding portion 10a is formed so as to have a height (length) H1 (see FIG. 1 (b)) of 2 to 5 mm and the second protruding portion 10b is also formed so as to have a height (length) H2 (see FIG. 1 (b)) of 2 to 5 mm, and this is for the following reasons. That is, when the size of the resistance element 10 itself needs to be reduced to adjust the resistance value and if the first protruding portion 10a were formed so as to have a height (length) H1 (see FIG. 1 (b)) of less than 2 mm and the second protruding portion 10b were also formed so as to have a height (length) H2 (see FIG. 1 (b)) of less than 2 mm, it might be necessary to provide such a notched portion 101b as shown in FIG. 4 and therefore it might not be possible to measure the current value accurately. Also, when the shunt resistor 1 is installed on a current path through which a large current flows from a battery for high-voltage applications to a motor circuit that are used in, for example, electric vehicles (EVs), hybrid vehicles (HVs), and plug-in hybrid vehicles (PHVs) and if the first protruding portion 10a were formed so as to have a height (length) H1 (see FIG. 1 (b)) of more than 5 mm and the second protruding portion 10b were also formed so as to have a height (length) H2 (see FIG. 1 (b)) of more than 5 mm, the shunt resistor 1 might come into contact with other devices or parts and therefore it might not be possible to measure the current value accurately. It is therefore the invention to form the first protruding portion 10a so as to have a height (length) H1 (see FIG. 1 (b)) of 2 to 5 mm and also the second protruding portion 10b to have a height (length) H2 (see FIG. 1 (b)) of 2 to 5 mm. Accordingly, by forming the first protruding portion 10a to have a height (length) H1 (see FIG. 1 (b)) of 2 to 5 mm and also the second protruding portion 10b so as to have a height (length) H2 (see FIG. 1 (b)) of 2 to 5 mm, even if the need for reducing the size of the resistance element 10 itself to adjust the resistance value arises, the size of the resistance element 10 itself can be reduced to adjust the resistance value without providing such a notched portion 101b as shown in FIG. 4, and further it is possible to avoid contact with other devices or parts. This configuration according to the invention can thus achieve an accurate current value measurement even when a large current flows.

Another embodiment describes an example in which laser welding not shown is used under a non-vacuum environment to join the side surface 11c of the base material 11 on the left side in the drawing by welding 10e to the left side surface 10c of the resistance element 10, while joining the side surface 11c of the base material 11 on the right side in the drawing by welding 10e to the right side surface 10d of the resistance element 10, as shown in FIG. 2 (c), but an electron beam may be used for welding.

However, welding using an electron beam requires performing welding under a vacuum environment. For such welding under a vacuum environment while clamping by using a clamping mechanism not shown as in this embodiment, it is very difficult to automate the welding operation. It is therefore preferable to use laser welding not shown for welding under a non-vacuum environment, because using laser welding not shown under a non-vacuum environment allows for easy automation of the welding operation. This can improve mass productivity.

Incidentally, the shape of the resistance element 10, the base materials 11, and the measurement terminals 12 described in this embodiment is merely an example, and various modifications and changes are possible without departing from the spirit and scope of the present invention as defined in the appended claims. For example, this embodiment describes an example of the resistance element 10 in which the first protruding portion 10a is provided on the upper side of the resistance element 10 and the second protruding portion 10b is provided on the lower side of the resistance element 10, but without being limited thereto, only either one of the first protruding portion 10a and the second protruding portion 10b may be provided. This also allows the two base materials 11 and the first protruding portion 10a and the second protruding portion 10b of the resistance element 10 to be clamped by a well-known clamping mechanism not shown. It is however preferable to provide the first protruding portion 10a on the upper side of the resistance element 10 and provide the second protruding portion 10b on the lower side of the resistance element 10, because this allows the resistance element 10 to be clamped stably by a well-known clamping mechanism not shown.

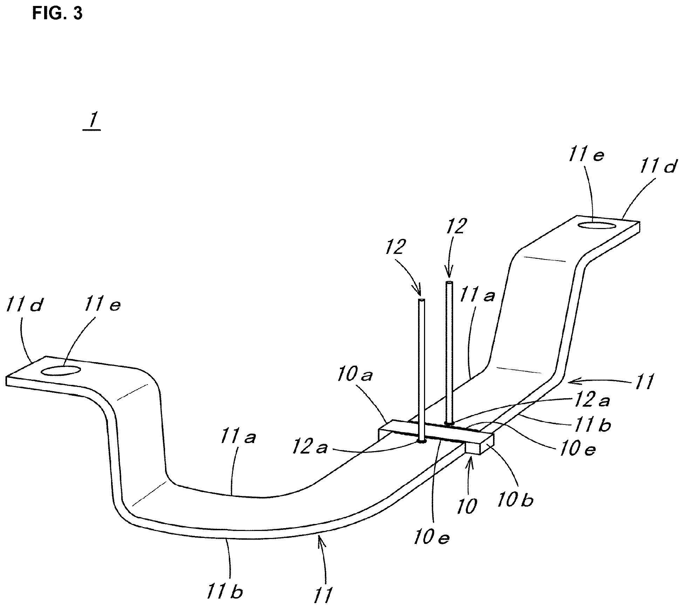

This embodiment also describes an example of the shape of the base material 11 in which the base materials 11 are each formed in a lengthened rectangular shape, but without being limited thereto, the present invention can also be applied to base materials 11 that have undergone a bending process, as shown in FIG. 3. In particular, since the conventional continuous welding method cannot be employed to manufacture a shunt resistor 1 using such base materials 11 that have undergone a bending process, the manufacturing method according to this embodiment described with reference to FIG. 2 is of particular benefit.

### Industrial Applicability

The shunt resistor 1 exemplified in the above-described embodiments is particularly useful to measure the current value on a current path through which a large current flows from a battery for high-voltage applications to a motor circuit that are used in, for example, electric vehicles (EVs), hybrid vehicles (HVs), and plug-in hybrid vehicles (PHVs).

### Reference Signs List

1 Shunt resistor
10 Resistance element
10a First protruding portion (protruding portion)
10b Second protruding portion (protruding portion)
10e Welding
11 Base material
11a One side surface
11b Other side surface
12 Measurement terminal

## Claims

1. A shunt resistor having:
a resistance element (10); and
two base materials (11) joined by welding (10e) to the resistance element (10) with the resistance element (10) therebetween wherein
the resistance element (10) is provided with a protruding portion (10a) that protrudes from at least one (11a) of longitudinal side surfaces (11a, 11b) of the two base materials (11), **characterized in that** the protruding portion is formed so as to have a height (H1, H2) of 2 to 5 mm.

2. The shunt resistor according to claim 1, **characterized in that** the resistance element (10) is provided with protruding portions (10a, 10b) that protrude from the longitudinal side surfaces (11a, 11b) of the two base materials (11).

3. A method for manufacturing a shunt resistor according to claim 1 with a resistance element (10) between two base materials (11), the method being **characterized by** comprising:
forming the resistance element (10) so as to be provided with a protruding portion (10a) that protrudes from at least one (11a) of longitudinal side surfaces (11a, 11b) of the two base materials (11) when the resistance element (10) is sandwiched between the two base materials (11); and
clamping and joining by welding (10e) the protruding portion (10a) of the resistance element (10) and the two base materials (11) when joining by welding (10e) the two base materials (11) to the resistance element (10) with the resistance element (10) therebetween.

## Patentansprüche

1. Shunt-Widerstand aufweisend:
ein Widerstandselement (10); und
zwei Basismaterialien (11), die durch Schweißen (10e) mit dem Widerstandselement (10) verbunden sind, wobei sich das Widerstandselement (10) dazwischen befindet, wobei
das Widerstandselement (10) mit einem vorstehenden Abschnitt (10a) versehen ist, der aus mindestens einer (11a) der Längsseitenflächen (11a, 11b) der beiden Basismaterialien (11) vorsteht, **dadurch gekennzeichnet, dass** der vorstehende Abschnitt so ausgebildet ist, dass er eine Höhe (H1, H2) von 2 bis 5 mm aufweist.

2. Shunt-Widerstand nach Anspruch 1, **dadurch gekennzeichnet, dass** das Widerstandselement (10) mit vorspringenden Abschnitten (10a, 10b) versehen ist, die von den Längsseitenflächen (11a, 11b) der beiden Basismaterialien (11) vorstehen.

3. Verfahren zur Herstellung eines Shunt-Widerstands nach Anspruch 1 mit einem Widerstandselement (10) zwischen zwei Basismaterialien (11), wobei das Verfahren **dadurch gekennzeichnet ist, dass** es Folgendes umfasst:
Formen des Widerstandselements (10), sodass es mit einem vorstehenden Abschnitt (10a) versehen ist, der von mindestens einer (11a) der Längsseitenflächen (11a, 11b) der beiden Basismaterialien (11) vorsteht, wenn das Widerstandselement (10) zwischen den beiden Basismaterialien (11) angeordnet ist; und
Einklemmen und Verbinden durch Schweißen (10e) des vorstehenden Abschnitts (10a) des Widerstandselements (10) und der beiden Basismaterialien (11) beim Verbinden durch Schweißen (10e) der beiden Basismaterialien (11) mit dem Widerstandselement (10), wobei das Widerstandselement (10) dazwischen liegt.

## Revendications

1. Résistance de dérivation présentant :
un élément résistif (10) ; et
deux matériaux de base (11) assemblés par soudage (10e) à l'élément résistif (10) avec l'élément résistif (10) situé entre ceux-ci dans laquelle
l'élément résistif (10) est pourvu d'une portion en saillie (10a) qui est en saillie depuis au moins une (11a) des surfaces latérales longitudinales (11a, 11b) des deux matériaux de base (11), **caractérisée en ce que** la portion en saillie est formée de façon à présenter une hauteur (H1, H2) de 2 à 5 mm.

2. Résistance de dérivation selon la revendication 1, **caractérisée en ce que** l'élément résistif (10) est pourvu de portions en saillie (10a, 10b) qui sont en saillie depuis les surfaces latérales longitudinales (11a, 11b) des deux matériaux de base (11).

3. Procédé de fabrication une résistance de dérivation selon la revendication 1 avec un élément résistif (10) entre deux matériaux de base (11), le procédé étant **caractérisé en ce qu'**il comprend :
la formation de l'élément résistif (10) de façon à être pourvu d'une portion en saillie (10a) qui est en saillie depuis au moins une (11a) des surfaces latérales longitudinales (11a, 11b) des deux matériaux de base (11) lorsque l'élément résistif (10) est pris en sandwich entre les deux matériaux de base (11) ; et
serrer et assembler par soudage (10e) la portion en saillie (10a) de l'élément résistif (10) et les deux matériaux de base (11) lorsqu'on assemble par soudage (10e) les deux matériaux de base (11) à l'élément résistif (10) avec l'élément résistif (10) entre ceux-ci.
